# DEMANDE DE BREVET EUROPEEN

(11) **EP 4 669 048 A1**
(43) Date de publication de la demande: **24.12.2025**
(21) Numéro de dépôt: 25181041.2
(22) Date de dépôt: 05.06.2025
(51) Int. Cl.: H10B 41/35, H10D 64/01

(54) **CIRCUIT DE MÉMOIRE NON VOLATILE ET PROCÉDÉ DE FABRICATION D'UN TEL CIRCUIT DE MÉMOIRE**

(30) Priorité: 19.06.2024 FR 2406569
(71) Demandeur: STMicroelectronics International N.V., 1228 Plan-les-Ouates, Geneva (CH)
(72) Inventeur: RIVERO, Christian, 13790 Peynier (FR); DELALLEAU, Julien, 13790 Rousset (FR)
(74) Mandataire: Casalonga

(57) **Abrégé**

Selon un aspect, il est proposé un circuit de mémoire non volatile comprenant une matrice de cellules mémoire, chaque cellule-mémoire comprenant :
- un transistor d'état (T) ayant une grille de commande (CG) et une grille flottante (FG), sélectionnable par un transistor de sélection (ST) vertical enterré dans un substrat (SB) et comportant une grille de sélection (CSG) enterrée,

la grille de sélection (CSG) étant commune entre les transistors de sélection (ST) d'une même paire de cellules mémoire, les grilles de sélection étant formées dans une même région de grilles de sélection (R S G),
dans lequel la région de grilles de sélection (RSG) présente un renfoncement (RCS) en surface entre chaque paire de cellules mémoire jumelles, le renfoncement (RCS) étant configuré pour réduire un couplage par effet tunnel entre les grilles flottantes (FG) des transistors d'état (T) et la région de grilles de sélection (RSG).

## Description

Des modes de réalisation et de mise en œuvre concernent les mémoires non volatiles à stockage de charge.

La publication « 40nm embedded Select in Trench Memory (eSTM) Technology Overview », F. La Rosa et al, 2019, décrit un circuit de mémoire non volatile à stockage de charge. Ce circuit utilise des grilles flottantes pour retenir des charges pour stocker des informations.

En particulier, ce circuit comporte une matrice de cellules mémoire ayant deux rangées et N colonnes. Chaque colonne de cellules mémoire inclut une paire de cellules mémoire jumelles. Chaque cellule-mémoire comprend un transistor de sélection et un transistor d'état. Le transistor d'état présente une grille de commande et une grille flottante. La grille flottante d'un transistor d'état est sélectionnable par le transistor de sélection. Le transistor de sélection s'étend verticalement dans le substrat. En particulier, ce transistor de sélection comprend une grille de sélection enterrée. Cette grille de sélection est commune entre les deux transistors de sélection d'une même paire de cellules mémoire jumelles.

Les différentes paires de cellules mémoire jumelles sont séparées les unes des autres par des tranchées d'isolation peu profondes (désignées également par l'abréviation « STI » de l'anglais « Shallow Trench Isolation »). Les grilles de sélection commune associées aux différentes paires de cellules mémoire jumelles sont formées dans une même région de grilles de sélection traversant lesdites tranchées d'isolation peu profondes. Cette région de grilles de sélection permet alors de définir une ligne d'un mot (en anglais « wordline »).

Ainsi, la région de grilles de sélection présente des zones situées entre deux cellules mémoire jumelles d'une même paire et des zones situées entre les paires de cellules mémoire jumelles dans la tranchée d'isolation peu profonde.

Les zones situées entre deux paires de cellules mémoire jumelles peuvent être plus larges que les zones situées entre deux cellules mémoire jumelles d'une même paire. Cet élargissement rapproche la région de grilles de sélection des grilles flottantes des différentes cellules-mémoire adjacentes.

Ce rapprochement peut causer un couplage par effet tunnel entre ces grilles flottantes et la région de grilles de sélection. Ce couplage peut entraîner un déchargement de l'information stockées par la grille flottante d'une cellule mémoire lorsque la cellule mémoire est accédée en lecture. L'information stockée dans une cellule mémoire peut ainsi devenir erronée après avoir été lue un certain nombre de fois. Afin de corriger une information stockée dans la cellule mémoire, des codes de correction d'erreur peuvent être utilisés mais leur mise en œuvre est complexe est coûteuse en ressources de calcul.

Afin de réduire le couplage par effet tunnel pour améliorer la fiabilité du circuit de mémoire, il est possible d'écarter les transistors d'état de la région de grille. Néanmoins, cette solution induit une augmentation de la surface planaire requise pour le circuit de mémoire.

Il existe donc un besoin de proposer une solution permettant de réduire le couplage entre les grilles flottantes et la région de grilles de sélection, sans augmenter les dimensions du circuit de mémoire.

Selon un aspect, il est proposé un circuit de mémoire non volatile comprenant une matrice de cellules mémoire comportant au moins deux rangées et N colonnes, chaque cellule-mémoire comprenant :
- un transistor d'état ayant une grille de commande et une grille flottante, sélectionnable par un transistor de sélection vertical enterré dans un substrat et comportant une grille de sélection enterrée,

chaque colonne de cellules mémoire incluant une paire de cellules mémoire jumelles, la grille de sélection enterrée étant commune entre les transistors de sélection d'une même paire de cellules mémoire, les grilles de sélection étant disposées dans une même région de grilles de sélection,
et dans lequel la région de grilles de sélection présente un renfoncement en surface entre chaque paire de cellules mémoire jumelles.

Avantageusement, la grille de sélection enterrée s'étend uniquement dans le substrat.

Avantageusement, le renfoncement est configuré pour réduire un couplage par effet tunnel entre les grilles flottantes des transistors d'état et la région de grilles de sélection.

Le renfoncement permet d'éloigner la région de grilles des grilles flottantes entre deux paires de cellule mémoire. Ainsi, le renfoncement permet de réduire le couplage entre la région de grilles de sélection et les grilles flottantes entre deux paires de cellule mémoire. Un tel circuit de mémoire permet d'améliorer le stockage de données en réduisant les risques de pertes de données. En outre, un tel renfoncement permet d'éviter d'augmenter les dimensions du circuit de mémoire.

Avantageusement, le renfoncement présente une profondeur comprise entre 10 nanomètres et 200 nanomètres.

Dans un mode de réalisation avantageux, la région de grilles de sélection est recouverte d'une couche d'oxyde.

Avantageusement, le circuit de mémoire comprend en outre des régions diélectriques d'espacement contre des faces latérales des transistors d'état des cellules mémoire, les régions diélectriques d'espacement s'étendant en partie dans ledit renfoncement.

Selon un autre aspect, il est proposé un microcontrôleur comprenant un circuit de mémoire non volatile tel que décrit précédemment.

Selon un autre aspect, il est proposé un procédé de fabrication d'un circuit de mémoire non volatile comprenant :
- une formation d'une matrice de cellules mémoire comportant au moins deux rangées et N colonnes, chaque cellule-mémoire comprenant : chaque cellule-mémoire comprenant :
- un transistor d'état ayant une grille de commande et une grille flottante, sélectionnable par un transistor de sélection vertical enterré dans un substrat et comportant une grille de sélection enterrée,

chaque colonne de cellules mémoire incluant une paire de cellules mémoire jumelles, la grille de sélection enterrée étant commune entre les transistors de sélection d'une même paire de cellules mémoire, les grilles de sélection étant disposées dans une même région de grilles de sélection,
le procédé comprenant en outre une formation d'un renfoncement en surface de la région de grilles de sélection entre chaque paire de cellules mémoire jumelles.

Avantageusement, le renfoncement est configuré pour réduire un couplage par effet tunnel entre les grilles flottantes des transistors d'état et la région de grilles de sélection.

De préférence, la formation dudit renfoncement comprend :
- une formation d'un masque présentant des ouvertures au-dessus de la région de grilles de sélection entre chaque paire de cellules mémoire jumelles,
- une gravure des zones de la région de grilles de sélection en regard desdites ouvertures du masque pour former chaque renfoncement.

Un tel procédé de fabrication est simple et peu coûteux à mettre en œuvre. En particulier, la formation des renfoncements requiert simplement l'utilisation d'un masque additionnel puis une gravure des zones situées en regard des ouvertures du masque.

D'autres avantages et caractéristiques de l'invention apparaîtront à l'examen de la description détaillée de modes de réalisation, nullement limitatifs, et des dessins annexés sur lesquels :
[Fig 1]
[Fig 2]
[Fig 3]
[Fig 4]
[Fig 5]
[Fig 6]
[Fig 7]
[Fig 8]
[Fig 9]

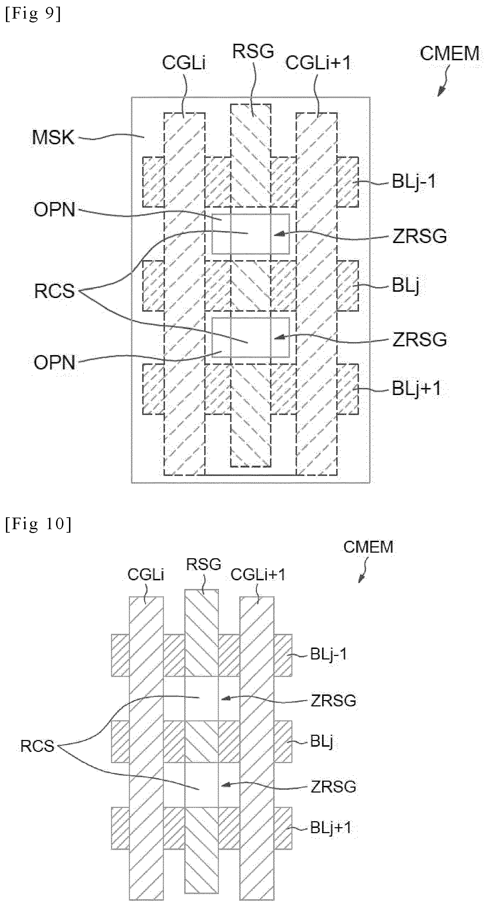

[Fig 10] illustrent des modes de réalisation et de mise en œuvre de l'invention.

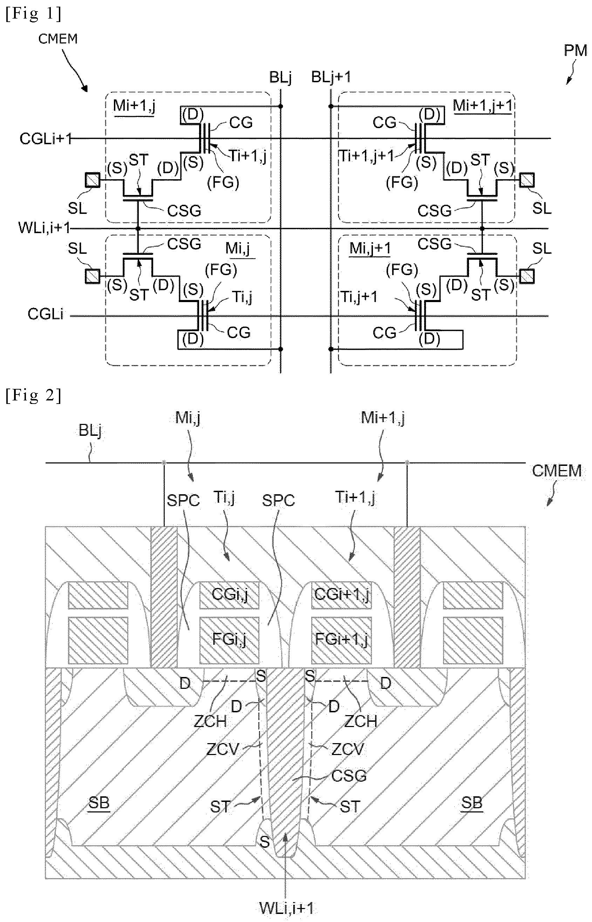

La figure 1 illustre un circuit de mémoire CMEM. Le circuit de mémoire CMEM comporte des cellules mémoire non volatile. Le circuit de mémoire CMEM peut être compris dans un microcontrôleur (non représenté) par exemple.

Sur la figure 1, à des fins d'illustration, seules quatre cellules mémoire Mi,j ; Mi,j+1 ; Mi+1,j ; Mi+1,j+1 sont représentées.

Les cellules mémoire Mi,j et Mi,j+1 de rang "i" appartiennent à la ligne ou rangée de rang i du circuit de mémoire et sont reliées à une ligne de mot WLi,i+1 et à une ligne de contrôle de grille CGLi.

Les cellules mémoire Mi+1,j et Mi+1,j+1 de rang "i+1" appartiennent à la ligne ou rangée de rang "i+1" du circuit de mémoire et sont reliées à la ligne de mot WLi,i+1 et à une ligne de contrôle de grille CGLi+1.

Les cellules mémoire Mi,j et Mi+1,j de rang "j" appartenant à la colonne j sont accessibles en lecture et écriture par l'intermédiaire d'une seule ligne de bit BLj et les cellules mémoire Mi,j+1 et Mi+1,j+1 de rang "j+1" sont accessibles en lecture et écriture par l'intermédiaire d'une seule ligne de bit BLj+1.

Chaque cellule mémoire M comprend un transistor d'état T (Ti,j ; Ti,j+1 ; Ti+1,j ; Ti+1,j+1) et un transistor de sélection ST. Le transistor d'état T est configuré pour stocker une information. Le transistor de sélection ST est configuré pour sélectionner le transistor d'état T pour lire ou écrire une information dans le transistor d'état T.

En particulier, le transistor d'état T comporte une grille flottante (FG) surmontée par une grille de commande CG reliée à une ligne de contrôle de grille CGL. La grille flottante permet de stocker une information.

Le drain (D) du transistor d'état T est relié à une ligne de bits BL tandis que la source (S) du transistor d'état T est reliée à un drain du transistor de sélection ST. En particulier, les régions de drain (D) des transistors Ti,j et Ti+1,j sont connectées à la ligne de bit BLj et les bornes de drain des transistors Ti,j+1 et Ti+1,j+1 sont connectées à la ligne de bit BLj+1. Les grilles de commande CG des transistors Ti,j et Ti,j+1 sont connectées à la ligne de contrôle de grille CGLi et les grilles de commande CG des transistors à grille flottante Ti+1,j et Ti+1,j+1 sont connectées à la ligne de contrôle de grille CGLi+1.

Le transistor de sélection ST comporte une source (S) reliée à une ligne de source SL. Ainsi, chaque transistor d'état T est relié à une ligne de source SL par l'intermédiaire du transistor de sélection ST.

Les transistors de sélection ST des cellules mémoire Mi,j et Mi+1,j ont une grille de sélection commune CSG et les deux cellules mémoire sont, de ce fait, dites "jumelles". De même, des cellules mémoire Mi,j+1 et Mi+1,j+1 sont des cellules mémoire jumelles et leurs transistors de sélection ST ont une grille de sélection commune CSG.

Chaque grille de sélection CSG est une grille verticale enterrée dans un substrat dans lequel le circuit de mémoire PM est réalisé, la ligne de source SL étant également enterrée. Ces grilles de sélection communes CSG de cellules mémoire jumelles, sont connectées à la ligne de mot WLi,i+1.

La figure 2 illustre plus précisément deux cellules jumelles Mi,j et Mi+1,j appartenant à la même colonne j et aux deux lignes i et i+1. Les deux cellules jumelles Mi,j et Mi+1,j appartiennent à une même paire de cellules jumelles. La figure 2 est une vue en coupe transversale de cette paire de cellules jumelles.

Chaque transistor d'état présente un canal ZCH entre son drain D et sa source S. Leur drain D est connecté à la même ligne de bits BLj qui est la seule ligne de bits pour la colonne j.

Le canal ZCH du transistor d'état est avantageusement un canal surfacique de sorte qu'il puisse être possible de pouvoir bloquer la conduction du canal par application d'une tension de commande acceptable sur la grille de commande du transistor d'état.

Chaque transistor d'état T coopère avec un transistor de sélection ST vertical enterré dans le substrat SB.

Les transistors de sélection ST connectés aux deux transistors d'états Ti,j et Ti+1,j ont chacun un canal vertical ZCV et une grille de sélection commune verticale enterrée CSG. Il convient de noter qu'à des fins de simplifications de la figure, le contact permettant de relier la grille de sélection commune enterrée CSG à la ligne de mots correspondante WLi,i+1, n'est pas représenté.

Le canal vertical ZCV de chaque transistor de sélection ST s'étend entre un drain D1, formé dans la même région que la source du transistor d'état de la même cellule mémoire, et une source S1 formée dans une région de diffusion enterrée.

Chaque cellule-mémoire a un premier état, par exemple un état effacé, dans lequel elle stocke un bit ayant une première valeur logique, par exemple la valeur logique 1, et un deuxième état, par exemple un état programmé, dans lequel elle stocke un bit ayant une deuxième valeur logique, par exemple la valeur logique 0.

Le transistor d'état d'une cellule-mémoire est avantageusement configuré pour être passant lorsque la cellule-mémoire est dans son premier état et pour être bloqué lorsque la cellule-mémoire est dans son deuxième état.

Les grilles de sélection communes enterrées CSG des cellules mémoire jumelles d'une même ligne de mots sont formées dans une même région de grilles de sélection RSG. Cette région de grilles de sélection RSG s'étend donc longitudinalement entre chaque cellules mémoire jumelles d'une même paire et entre chaque paire de cellules mémoire jumelles. En particulier, la région de grilles de sélection RSG s'étend entre les paires de cellules mémoire jumelles dans des tranchées d'isolation peu profonde STI (en l'anglais « Shallow Trench Isolation »).

Cette région de grilles de sélection RSG présente une épaisseur qui varie sur sa longueur. L'épaisseur de la région de grilles de sélection RSG correspond à la distance verticale entre une extrémité en surface de la région de grilles de sélection et une extrémité enterrée de la région de grilles de sélection.

La figure 2 illustre également des régions diélectriques d'espacement SPC disposées contre les faces latérales des lignes de contrôle de grille des transistors d'état.

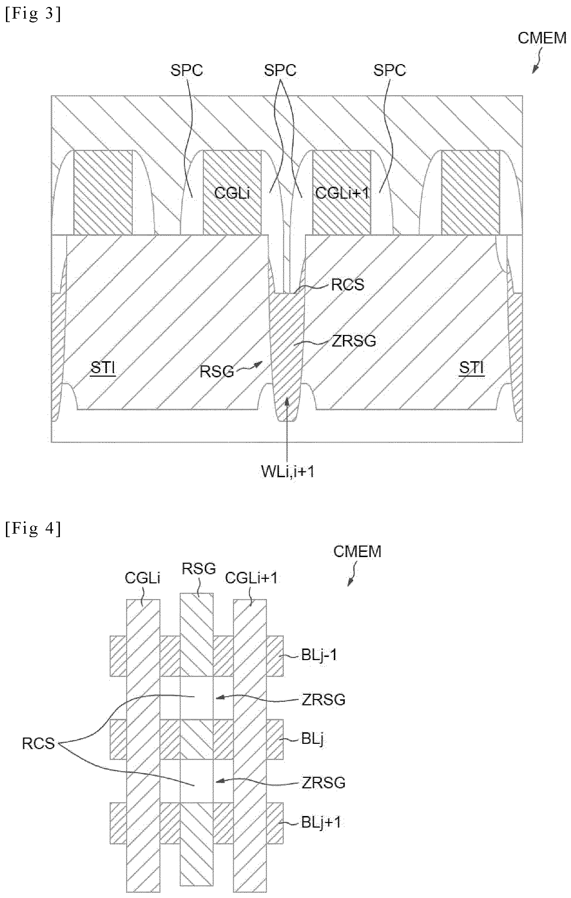

En particulier, comme illustré à la figure 3 qui montre une coupe transversale entre deux paires de cellules mémoire, la région de grille présente des zones ZRSG à épaisseur réduite depuis l'extrémité en surface entre chaque paire de cellules mémoire jumelles dans la zone des tranchées d'isolation peu profonde STI. En particulier, les zones ZRSG à épaisseur réduite sont creusées à partir de l'extrémité en surface. Ces zones ZRSG présentent donc chacune un renfoncement RCS. Cela permet d'écarter la région de grilles de sélection entre deux paires de cellules mémoire jumelles des grilles flottantes de ces cellules mémoire jumelles. Ainsi, le renfoncement RCS permet de réduire le couplage entre la région de grilles de sélection et les grilles flottantes entre deux paires de cellule mémoire. Un tel circuit de mémoire permet d'améliorer le stockage de données en réduisant les risques de pertes de données. En outre, un tel renfoncement RCS permet d'éviter d'augmenter les dimensions du circuit de mémoire.

Plus particulièrement, le renfoncement RCS présente une profondeur comprise entre 10 nanomètres et 200 nanomètres.

La figure 4 illustre une vue de dessus d'une portion du circuit de mémoire. Cette portion de mémoire montre deux zones ZRSG présentant chacune un renfoncement RCS. Une première zone ZRSG est située entre les lignes de bit BLj-1 et BLj et entre les lignes de contrôle de grille CGLi et CGLi+1. Une deuxième zone ZRSG est située entre les lignes de bit BLj et BLj+1 et entre les lignes de contrôle de grille CGLi et CGLi+1. La figure 4 n'illustre pas les régions diélectriques d'espacement SPC afin de simplifier la vue.

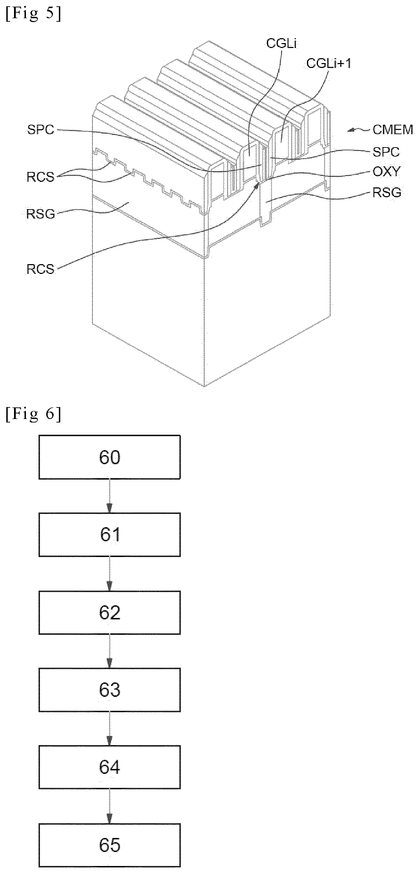

La figure 5 illustre une vue tridimensionnelle d'une portion d'un circuit de mémoire tel que décrit précédemment. Cette figure 5 montre les renfoncements RCS situés sur la longueur de la région de grilles de sélection RSG entre chaque paire de cellules mémoire jumelles. Cette figure montre également les régions diélectriques d'espacement SPC qui s'étendent contre les faces latérales des lignes de contrôle de grille des transistors d'état et en partie dans ledit renfoncement RCS.

La région de grilles de sélection RSG est déposée sur une première couche d'oxyde OXY1 et est recouverte par une deuxième couche d'oxyde OXY également en surface. Cette deuxième couche d'oxyde OXY s'étend notamment dans les renfoncements RCS de la région de grilles de sélection RSG.

Les figures 6 illustrent un exemple de mise en œuvre d'un procédé de fabrication d'un circuit de mémoire tel que décrit précédemment.

Le procédé de fabrication comprend une fabrication 60 de paires de cellules mémoire jumelles, chaque cellule de mémoire jumelle présentant un transistor d'état et un transistor de sélection. La fabrication des paires de cellules mémoire jumelles est bien connue par l'homme du métier. Les grilles CSG des transistors de sélection reliées à une même ligne de mots WL sont formées dans une même région RSG de grilles de sélection s'étendant en profondeur dans le substrat. La région des grilles de sélection présente à ce stade des zones ENL élargies entre les paires de cellules mémoire jumelles.

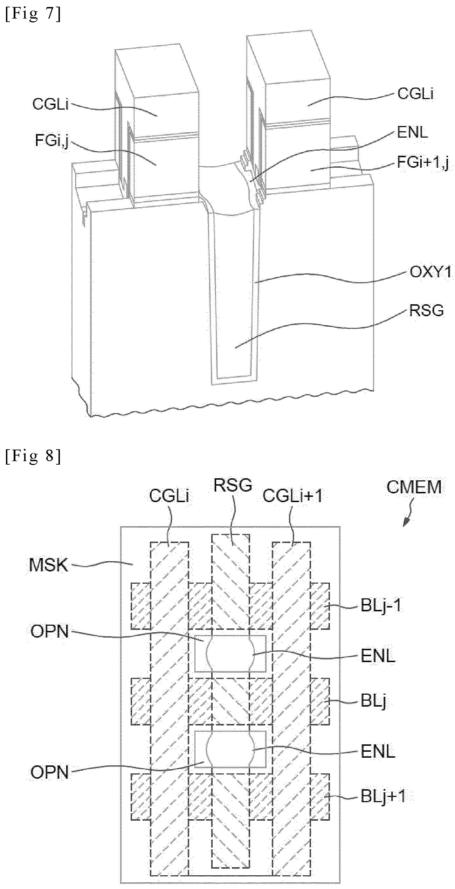

La figure 7 illustre un résultat pouvant être obtenu après avoir réalisé la fabrication des paires de cellules mémoire jumelles.

Le procédé de fabrication comprend ensuite un dépôt 61 d'un masque MSK. La figure 8 illustre le résultat obtenu après le dépôt 61 du masque MSK. En particulier, le masque MSK est configuré pour présenter des ouvertures OPN en regard des zones de la région de grilles de sélection situées entre les paires de cellules mémoire jumelles. Ainsi, le masque MSK est configuré pour recouvrir chaque paire de cellules mémoire jumelles ainsi que sur les zones de la région de grilles de sélection entre les cellules mémoire jumelles. Le masque est également configuré pour recouvrir les zones des lignes de contrôle de grilles CG1, CG2 situées entre les paires de cellules mémoire.

Le procédé comprend ensuite une gravure 62 des zones non recouvertes par le masque, c'est-à-dire les zones ZRSG de la région de grilles de sélection CSG situées entre les paires de cellules mémoire jumelles en regard des ouvertures OPN du masque MSK. De préférence, la gravure 62 est une gravure sèche, notamment une gravure au plasma. La figure 9 illustre une vue de dessus d'un exemple de résultat de l'étape 62 de gravure.

Le procédé comprend ensuite un retrait 63 du masque MSK. La figure 10 illustre une vue de dessus d'un exemple de résultat du retrait du masque MSK.

Le procédé comprend ensuite un dépôt 64 d'une couche d'oxyde OXY sur les cellules mémoire et sur la région de grilles de sélection.

Le procédé comprend ensuite un dépôt 65 de régions diélectriques d'espacement SPC contre les faces latérales des transistors d'état des cellules mémoire. Ces régions diélectriques d'espacement SPC s'étendent également dans les renfoncements RCS de la région de grilles de sélection.

Un tel procédé de fabrication est simple et peu coûteux à mettre en œuvre. En particulier, la formation des renfoncements RCS requiert simplement l'utilisation d'un masque MSK additionnel puis une gravure des zones ZRSG situées en regard des ouvertures du masque MSK.

## Revendications

1. Circuit de mémoire non volatile comprenant une matrice de cellules mémoire comportant au moins deux rangées et N colonnes, chaque cellule-mémoire comprenant :
- un transistor d'état (T) ayant une grille de commande (CG) et une grille flottante (FG), sélectionnable par un transistor de sélection (ST) vertical enterré dans un substrat (SB) et comportant une grille de sélection (CSG) enterrée,
chaque colonne de cellules mémoire incluant une paire de cellules mémoire jumelles, la grille de sélection (CSG) enterrée étant commune entre les transistors de sélection (ST) d'une même paire de cellules mémoire, les grilles de sélection étant disposées dans une même région de grilles de sélection (RSG),
et dans lequel la région de grilles de sélection (RSG) présente un renfoncement (RCS) en surface entre chaque paire de cellules mémoire jumelles.

2. Circuit selon la revendication 1, dans lequel le renfoncement (RCS) est configuré pour réduire un couplage par effet tunnel entre les grilles flottantes (FG) des transistors d'état (T) et la région de grilles de sélection (RSG).

3. Circuit selon l'une quelconque des revendications 1 ou 2, dans lequel le renfoncement (RCS) présente une profondeur comprise entre 10 nanomètres et 200 nanomètres.

4. Circuit selon l'une quelconque des revendications 1 à 3, dans lequel la région de grilles de sélection (RSG) est recouverte d'une couche d'oxyde (OXY).

5. Circuit selon l'une des revendications 1 à 4, comprenant en outre des régions diélectriques d'espacement (SPC) contre des faces latérales des transistors d'état (T) des cellules mémoire, les régions diélectriques d'espacement (SPC) s'étendant en partie dans ledit renfoncement (RCS).

6. Microcontrôleur comprenant un circuit de mémoire non volatile selon l'une des revendications 1 à 5.

7. Procédé de fabrication d'un circuit de mémoire non volatile comprenant :
- une formation d'une matrice de cellules mémoire comportant au moins deux rangées et N colonnes, chaque cellule-mémoire comprenant : chaque cellule-mémoire comprenant :
- un transistor d'état (T) ayant une grille de commande (CG) et une grille flottante (FG), sélectionnable par un transistor de sélection (ST) vertical enterré dans un substrat (SB) et comportant une grille de sélection (CSG) enterrée,
chaque colonne de cellules mémoire incluant une paire de cellules mémoire jumelles, la grille de sélection (CSG) enterrée étant commune entre les transistors de sélection (ST) d'une même paire de cellules mémoire, les grilles de sélection étant disposées dans une même région de grilles de sélection (RSG),
le procédé comprenant en outre une formation d'un renfoncement (RCS) en surface de la région de grilles de sélection (RSG) entre chaque paire de cellules mémoire jumelles.

8. Procédé selon la revendication 7, dans lequel le renfoncement (RCS) est configuré pour réduire un couplage par effet tunnel entre les grilles flottantes (FG) des transistors d'état et la région de grilles de sélection (RSG).

9. Procédé selon l'une des revendications 7 ou 8, dans lequel la formation dudit renfoncement comprend :
- une formation d'un masque (MSK) présentant des ouvertures (OPN) au-dessus de la région de grilles de sélection entre chaque paire de cellules mémoire jumelles,
- une gravure des zones (ZRSG) de la région de grilles de sélection en regard desdites ouvertures (OPN) du masque (MSK) pour former chaque renfoncement (RCS).
